# EUROPEAN PATENT APPLICATION

(11) **EP 2 782 436 A2**
(43) Date of publication of application: **24.09.2014**
(21) Application number: 14152426.4
(22) Date of filing: 24.01.2014
(51) Int. Cl.: H05K 9/00

(54) **Radio wave invention**

(30) Priority: 22.03.2013 JP 2013060261
(71) Applicant: Kabushiki Kaisha Riken, Chiyoda-ku, Tokyo 102-8202 (JP)
(72) Inventor: Hirose, Keita, Saitama 3608522 (JP); Ono, Takashi, Saitama 3608522 (JP)
(74) Representative: HGF Limited

(57) **Abstract**

An object of the present invention is to provide a radio wave absorber at low cost that has an excellent radio wave absorption property for absorbing microwaves and millimeter waves and hardly deteriorates the radio wave absorption property even after exposure to high-power radio waves. Specifically, the radio wave absorber according to the present invention for absorbing the microwaves and the millimeter waves is characterized in having a base material made of a porous compact containing composite oxide of calcium and aluminum; and a conductive material added to the base material.

## Description

### TECHNICAL FIELD

The present invention relates to a radio wave absorber, and more specifically, to a radio wave absorber with an excellent radio wave absorption property for absorbing microwaves and millimeter waves that is used for, for example, an anechoic chamber.

### BACKGROUND ART

In recent years, there are numerous electromagnetic wave generation sources surrounding us such as electronic devices, communication equipments, information systems and the like that coexist radiating a variety of electromagnetic waves. The electromagnetic waves generated from those devices/equipments may possibly affect nearby equipments and are also affected by the nearby equipments. In order to allow coexistence of a wide variety of devices/equipments in such an environment, an EMC (Electro-Magnetic Compatibility) strategy to have no effect on the nearby devices/equipments and also to be free of influence of the nearby devices/equipments has been required.

As time changes, the electronic devices and the communication equipments have changed from products using a low frequency band to products using a high frequency band. In recent years, the number of products using the microwaves (radio waves with frequencies at 1 GHz to 30 GHz) and millimeter waves (radio waves with frequencies at 30 GHz to 300 GHz) have been increasing. For example, a fourth-generation mobile phone (4 GHz), an ultra-high-speed wireless LAN (60 GHz), a vehicle-mounted millimeter wave radar (77 GHz), and the like may be mentioned. Also, a situation in which the microwaves and the millimeter waves are utilized for a high-power irradiation radar and the like used in aerospace and military businesses has been becoming common, and thus the microwaves and the millimeter waves have begun to be used in a wide range of fields.

As the number of products using such radio waves increases, development of standards for electromagnetic interference has also been promoted. Many of frequencies with allowance setting indicated in the standards heretofore were at 1GHz or less, and EMC measurement targeted mainly at 1GHz or less. However, in recent years, as mentioned above, because usage of high frequencies has become popular among the electronic devices, the frequencies with the allowance setting described in the standards have been revised to 18 GHz or less. It is easily imaginable that, in the future before entering a ubiquitous society, measurement of a higher frequency band will be required.

With a background described above, a microwave and millimeter wave anechoic chamber that allows EMC evaluation of products using a wide range of microwaves and millimeter waves from common electronic components to special high-power application has been required. To meet such a requirement, a radio wave absorber that has an excellent radio wave absorption property of the microwaves and the millimeter waves and hardly deteriorates the radio wave absorption property even after exposure to high-power radio waves is required.

Conventionally, there has been the radio wave absorber for absorbing the microwaves and the millimeter waves. Such a radio wave absorber is produced by kneading a base material made of polyurethane foam, polypropylene foam or polyethylene foam together with a carbon-based conductive material such as carbon black or graphite, or by impregnating the base material with the carbon-based conductive material, and forming the resulting material into a pyramidal shape.

However, organic materials such as polyurethane foam have poor heat resistance. The radio wave absorber, upon receiving the radio wave, internally converts the radio wave into heat and generates heat. Therefore, when the radio wave absorber having the base material made of the organic material receives a high-power radio wave emitted from a military radar or the like, the base material is damaged reducing its radio wave absorption property. Accordingly, it is difficult to use such radio wave absorber for receiving high-power radio waves.

As such, there has been suggested, in recent years, a radio wave absorber having inorganic material with high heat resistance for high-power usage. PLT 1 describes a radio wave absorber produced by preparing a base material formed in a pyramidal shape made of hydrated inorganic compounds such as hydrates of sepiolite, aluminum hydroxide, and calcium hydroxide and immersing the base material with carbon black coating, thereby imparting conductivity.

### CITATION LIST

### Patent Literature

PLT 1: JP 2003-115693 A

### SUMMARY OF INVENTION

### (Technical Problem)

However, Patent Document 1 merely temporality reduces momentum of heat by using crystallization water generated from the hydrated inorganic compounds upon application of the heat and thus is unable to satisfactorily accommodate high power. Also, the base material becomes brittle after being heated. Accordingly, the radio wave absorber having the base material made from the hydrated inorganic compounds is not applicable to the radar that emits high power.

Further, although using common inorganic material such as alumina, zirconia, silicon carbide or the like as the base material is also conceivable, these materials are very costly compared to the organic materials and thus increases manufacturing cost. For that reason, the radio wave absorber having the base material made from such materials to be used for high power has not been put into practical use.

The present invention, in consideration of the above problem, aims to provide a radio wave absorber at low cost that has an excellent radio wave absorption property for absorbing the microwaves and the millimeter waves and hardly deteriorates the radio wave absorption property even after exposure to high-power radio waves.

### (Solution to Problem)

In order to achieve the above object, the present inventors focused on calcium carbonate as an inorganic material that is available at low cost. When calcined, calcium carbonate tunes into a calcined calcium oxide body having high heat resistance. However, since calcium oxide is highly hygroscopic, the base material made of calcium oxide alone may not stably maintain its shape over time, and thus the radio wave absorber using such base material is not endurable to practical use. As such, the present inventors have conceived to use a sintered body constituting the base material in the form of a composite oxide of calcium and aluminum. Then, the present inventors have found that the radio wave absorber using the base material in the form of a porous compact containing the composite oxide of calcium and aluminum may achieve the above object, and thus accomplished the present invention.

That is, a radio wave absorber according to the present invention is a radio wave absorber for absorbing radio waves such as microwaves and millimeter waves that includes: a base material made of a porous compact containing composite oxide of calcium and aluminum; and a conductive material added to the base material.

Preferably, the base material made of the porous compact does not contain calcium oxide. Also preferably, a porosity of the porous compact is 10% to 70%.

Preferably, the conductive material is made of a fibrous carbon material having an aspect ratio of 100 or more, or carbon particles having a particle diameter of 0.2 µm or smaller. Conductive material content is preferably 0.5 to 10.0 mass% when the fibrous carbon material is used as the conductive material, or is 2 to 30 mass% when the carbon particles are used as the conductive material.

### (Advantageous Effect of Invention)

The radio wave absorber according to the present invention may be produced at low cost yet having an excellent radio wave absorption property for absorbing the microwaves and the millimeter waves and hardly deteriorating the radio wave absorption property even after exposure to high-power radio waves.

### BRIEF DESCRIPTION OF THE DRAWING

FIG. 1 is a perspective view of a radio wave absorber 10 according to one embodiment of the present invention.
FIG. 2 illustrates X-ray diffraction spectra of a porous compact containing composite oxide of calcium and aluminum that is used for the radio wave absorber according to the present invention: (A) illustrates the X-ray diffraction spectrum when a ratio of aluminum oxide in a raw material for producing the porous compact is 15.7 mass%, and (B) illustrates the X-ray diffraction spectrum when the ratio is 27.3 mass%.

### DESCRIPTION OF EMBODIMENTS

The following is a description of an embodiment of a radio wave absorber according to the present invention.

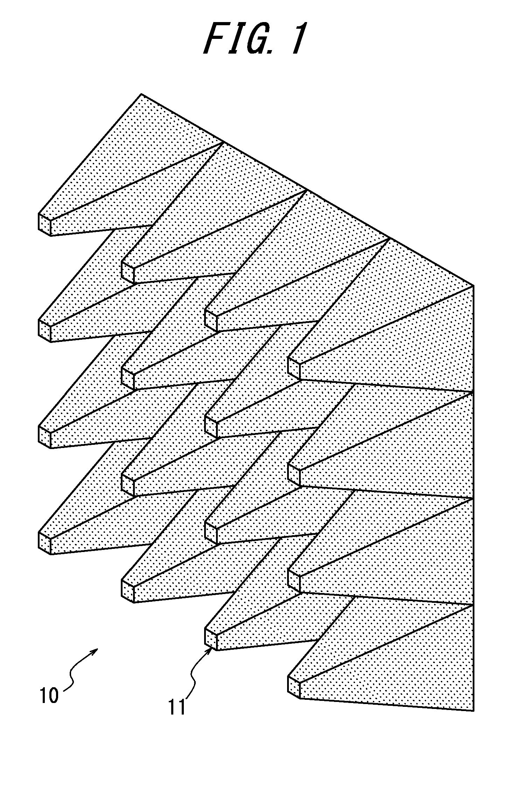

A radio wave absorber 10 according to one embodiment of the present invention, as illustrated in FIG. 1, includes a base material 11 made of a porous compact and a conductive material added to the base material 11. When the radio wave absorber 10 is exposed to a radio wave, conduction loss and dielectric loss are caused within the base material 11 by a combination of the conductive material and a dielectric material (the material of the base material 11 and a gap of the base material 11), and the radio wave is converted into heat. On a foregoing principle, the radio wave absorber 10 according to the present embodiment may absorb the radio waves such as microwaves and millimeter waves.

According to the present embodiment, the base material 11 is made of a porous compact containing composite oxide of calcium and aluminum. Since calcium oxide alone reacts with moisture in the air due to its high hygroscopicity and is turned into calcium hydroxide, a radio wave absorber made of calcium oxide alone is unstable. Also, alumina alone is very costly compared to organic materials and thus increases manufacturing cost. The present inventors have found that, by using the base material 11 containing the composite oxide of calcium and aluminum, a stable radio wave absorber having an excellent radio wave absorption property for absorbing the microwaves and the millimeter waves may be obtained. The radio wave absorber 10 having the base material 11 may be produced at low cost, as having inexpensive calcium carbonate as a main raw material. Also, since the base material 11 is made of an inorganic material, the base material 11 has high heat resistance and hardly gets damaged by high-power radiation. Accordingly, the radio wave absorption property of the radio wave absorber 10 hardly deteriorates after exposure to high-power radio waves.

In order to absorb a wide range of radio waves in a frequency band of the microwaves and the millimeter waves, the conductive material added to the base material 11 preferably has high conductivity per se and also, even when used in a small amount, may form a conductive network. Further, the conductive material preferably has high heat resistance. As typical materials having high conductivity, carbon and silicon carbide may be mentioned. In particular, carbon-based materials have been widely used as a conductive material of the radio wave absorber and the most appropriate material. As the carbon-based material, there are a fibrous carbon material and a particulate carbon material, and either of them may be used interchangeably.

As the fibrous carbon material, carbon fiber, carbon nanotube and the like may be mentioned. Since carbon nanotube, in particular, has very small bulk density compared to carbon fiber and may present high conductivity when used in a smaller amount than that of carbon fiber, carbon nanotube may be considered as an effective material.

As the particulate carbon material (carbon particles), carbon black and graphite may be mentioned. Since carbon black, in particular, has a very large specific surface area, carbon black in a smaller amount than that of graphite enables obtainment of high conductivity.

Here, an example of a producing method of the radio wave absorber 10 will be described. First, slurry is prepared from calcium carbonate powder, aluminum oxide powder, organic binder, disappearance beads (polystyrene beads), and the water. As the organic binder, polyvinyl alcohol or the like may be used. The slurry is molded into a pyramidal shape or a wedge shape by using a slip casting method utilizing a mold made of a gypsum board and the like. A compact thus obtained is calcined, and thereby the base material 11 made of a porous compact is obtained. As a preferable calcining condition, calcination temperature is 1000°C to 1500°C and calcination time is 2 to 5 hours. Also, the calcination may be atmospheric calcination.

Next, the conductive material is added to the base material 11 made of the porous compact. In particular, the porous compact is immersed with a solution having the conductive materials such as carbon nanotubes or the like dispersed therein, and then a resultant porous compact is calcined at low temperature. As a preferable calcining condition, calcination temperature is 200°C to 500°C and calcination time is 2 to 5 hours. Also, the calcination may be the atmospheric calcination. In this way, the conductive material is kneaded into the porous compact. The radio wave absorber 10 may be thus obtained.

Note that, as a method of adding the conductive material, the conductive material such as carbon nanotube or the like may be added to the slurry during production of the porous material in the pyramidal shape, such that the conductive material such as the carbon nanotube or the like is directly mixed into the porous compact during formation thereof. In this case, in order to prevent oxidation (burning) of the conductive material such as the carbon nanotube or the like, calcination is performed in a reducing atmosphere or in an atmosphere of inert gas such as N₂.

Preferably, the base material 11 made of the porous compact does not contain calcium oxide. That is, the base material 11 made of the porous compact is preferably composed of composite oxide of calcium and aluminum alone. To that end, in preparation of the composite oxide, a ratio of the mass of aluminum oxide needs to be 25 mass% or more relative to a total of the mass of calcium oxide (mass obtained by converting calcium carbonate into calcium oxide) and the mass of aluminum oxide. When the ratio of aluminum oxide is less than 25 mass%, unreacted calcium oxide remain in the base material 11, and the remaining calcium oxide absorbs moisture in the air. As a result, moisture resistance of the base material 11 becomes insufficient. When the ratio of aluminum oxide is 25 mass% or more, an excellent radio wave absorption property may be maintained over time even in a high humidity environment.

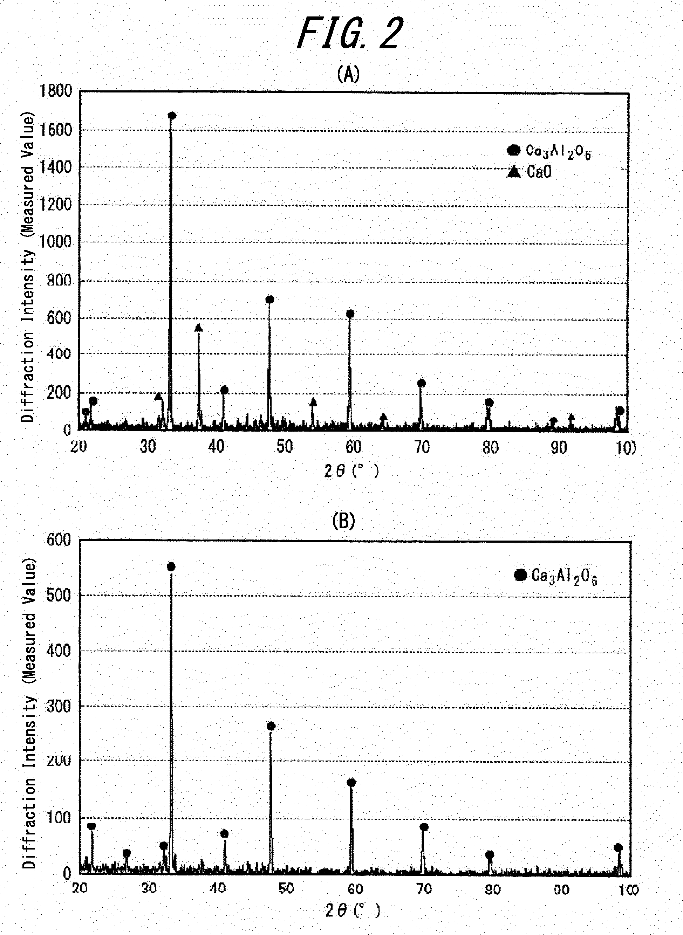

By way of example, FIG. 2(A) illustrates a result of X-ray diffraction of the porous compact with the ratio of aluminum oxide at 15.7 mass%, and FIG. 2(B) illustrates a result of the X-ray diffraction of the porous compact with the ratio of aluminum oxide at 27.3 mass%. FIG. 2(A) illustrates an X-ray diffraction spectrum of a porous compact produced in Example 3 described below, and FIG. 2(B) illustrates an X-ray diffraction spectrum of a porous compact produced in Example 1 also described below. In FIG. 2 (A), a peak of calcium oxide was detected, and calcium oxide was remaining in the porous compact. In FIG. 2(B), on the other hand, the peak of calcium oxide was not detected but composite oxide alone was detected. When the ratio of aluminum oxide is 25 mass% or more, all of calcium oxide react with aluminum oxide, and the porous compact contains generated composite oxide and remaining alumina component.

Although the aluminum oxide remaining in the porous compact does not affect a function of the compact, blending extra alumina is not preferable from a point of view of cost reduction. From this viewpoint, a preferable ratio of aluminum oxide is 50 mass% or less, most preferably 25 mass%.

A porosity of the porous compact is preferably 10% to 70%. When the porosity is 10% or more, a cost increase due to an excessive amount of the material being used is prevented and also the mass of the porous compact does not increase too much, thus facilitating handling the porous compact. Also, when the porosity is 70% or less, the compact does not deteriorate its strength. From this viewpoint, the porosity of the porous compact is more preferably 30% to 60%. The porosity of the compact may be adjusted by controlling an addition amount of the disappearance beads.

Note that the term "porosity of the porous compact" in the present specification means a ratio of holes (pores) in a volume (a volume obtained from an outer dimension including the holes) of the porous compact. The porosity may be calculated by the following method. First, a mass A of a porous compact as a measurement object is measured. Next, a mass B of another porous compact, which is produced under the same condition as that of the above porous compact except for having no disappearance beads added thereto and having the porosity of 0%, is measured. The porosity is calculated from the following formula: 100-massA/massB (%). Note that the porosity of the porous compact is obtained by conducting the measurement to the porous compact after addition of the conductive material thereto.

When the conductive material is the fibrous carbon material, a preferable aspect ratio is 100 or more. When the conductive material is the carbon particles, a preferable particle diameter is 0.2 µm or smaller. When the conductive materials in the same mass are added, one with a larger aspect ratio more facilitates connection between the fibers. Also, when the particle diameter is small, the number of particles is larger and thus a conductive network may be easily formed. Note that the term "aspect ratio" means an average value of a ratio of a length/width of each fibrous carbon in 10 particles in a view field when observed by SEM. Also, the term "particle diameter" means a particle diameter at a cumulative value of 50% in a particle size distribution (50% cumulative particle size: D50) obtained by using a laser diffraction scattering method.

Conductive material content, relative to the mass of the radio wave absorber (the mass of the base material and the conductive material) is preferably 0.5 to 10.0 mass% when the conductive material is the fibrous carbon material, or 2.0 to 30.0 mass% when the conductive material is the carbon particles. The conductive material content at these lower limits or more allows the porous compact to be imparted with sufficient conductivity and obtainment of excellent radio wave absorption property. Also, the conductive material content at these upper limits or less may prevent excessive conductivity of the porous compact and over-reflection of the radio waves on a surface thereof, thus allowing obtainment of excellent radio wave absorption property. More preferably, the conductive material content is 2.0 to 5.0 mass% when the conductive material is the fibrous carbon, or 5.0 to 15.0 mass% when the conductive material is the carbon particles.

### EXAMPLES

### (Examples 1 to 4)

Calcium carbonate and aluminum oxide as the raw materials were weighed so that the ratio of calcium oxide and aluminum oxide were set as shown in Table 1. Further, 2.0 parts by mass of organic binder (polyvinyl alcohol) and 1.0 parts by mass of the disappearance beads (polystyrene beads), both relative to the base material, were added. A resulting mixture was diluted with the water by 67 mass% and introduced to a ball mill (zirconia ball). Thus, slurry was prepared. Next, a gypsum board mold for molding into the pyramidal shape with a 150 mm square bottom and a height of 100 mm was prepared. The slurry described above was poured into the mold and then dried at normal temperature and normal humidity for five days to allow extraction of moisture therefrom. Thereby, 16 compacts in the pyramidal shape were prepared in each of Examples 1 to 4. The dried compacts were calcined at 1300°C for 5 hours, and thus the porous compacts in the pyramidal shape were produced.

Then, a solution (solvent: water) of carbon nanotube (produced by Showa Denko K.K.) having carbon nanotube content at a value shown in Table 2 was prepared. The porous compact was immersed with the solution, and then carbon nanotube was added. Note that an aspect ratio of the carbon nanotube was 200. Subsequently, the porous compact having the carbon nanotube added thereto was calcined at a low temperature of 300 °C in the atmosphere for 5 hours, and thus the radio wave absorber was obtained. The porosity of the porous compact is shown in Table 1.

**[Table 1]**

| | Example 1 | Example 2 | Example 3 | Example 4 |
|---|---|---|---|---|
| Calcium Oxide (mass%) | 72.7 | 78.5 | 84.3 | 72.7 |
| Aluminum Oxide (mass%) | 27.3 | 21.5 | 15.7 | 27.3 |
| Porosity of Porous Compact (%) | 25 | 30 | 35 | 25 |

**[Table 2]**

| | Example 1 | Example 2 | Example 3 | Example 4 |
|---|---|---|---|---|
| Base Material (mass%) | 97.9 | 97.8 | 97.8 | 99.4 |
| Carbon Nanotube (mass%) | 2.1 | 2.2 | 2.2 | 0.6 |

### (Evaluation method)

In Examples 1 to 4, measurement of radio wave absorption, a power durability test, and a hygroscopicity test were conducted.

### (1) Measurement of radio wave absorption

In Examples 1 to 4, 16 radio wave absorbers arranged in a four-by-four manner as illustrated in FIG. 1 was prepared, so as to obtain a specimen in 60 cm by 60 cm. The measurement of the radio wave absorption was conducted in a perpendicular incidence method by using a horn antenna produced by Keycom Corp. (2.6 GHz to 40 GHz, 8 antennas) and a vector network analyzer produced by Agilent Technologies Japan, Ltd. Results of the measurement are shown in a column headed "(A) Radio Wave Absorption" in Table 3.

### (2) Power durability test

After irradiation of an intense electric field of 700 V/m to a distal end of the radio wave absorber for 10 minutes, the radio wave absorption was measured in the same manner as (1) described above. Results of the measurement are shown in a column headed "(B) Radio Wave Absorption after Irradiation of High Power Radio Wave" in Table 3. A change of the radio wave absorption between (A) before irradiation and (B) after irradiation allows understanding power resistance property.

### (3) Hygroscopicity test

The hygroscopicity test was conducted by using a thermohygrostat (EY-101) produced by Espec Corp. Assuming use at time with highest temperature and humidity, under a condition with a temperature of 40°C and humidity of 95%, which is more intensive than a condition of the time set forth above, the radio wave absorber was left to stand for one month. After the test, the radio wave absorption was measured in the same manner as the above (1). Results of the measurement are shown in a column headed "(C) Radio Wave Absorption after Hygroscopicity Test" in Table 3. A change of the radio wave absorption between (A) before test and (B) after test allows understanding the moisture resistance. Also, presence of hygroscopicity based on a change in the mass of the radio wave absorber before and after the test is shown in a column headed "(D) Presence of Absorption".

### (Result of evaluation)

As clearly shown in Table 3, Examples 1 to 4 obtained excellent radio wave absorption property for the frequency band of the microwaves and the millimeter waves and, in particular, Examples 1 to 3 having 2.0 mass% or more of the carbon nanotube content obtained outstanding radio wave absorption property. In either of the embodiments, also, the radio wave absorption property did not deteriorate after irradiation of high-power radio waves.

Further, in Example 1 and Example 4, in which the ratio of the mass of aluminum oxide relative to the total of the mass of calcium oxide (mass obtained by converting calcium carbonate into calcium oxide) and the mass of aluminum oxide in production of the composite oxide was 27.3 mass%, calcium oxide did not remain in the porous compact. For this reason, moisture absorption of the radio wave absorber was not observed, and the radio wave absorption property did not deteriorate after the hygroscopicity test.

**[Table 3]**

| | Frequency (GHz) | (A) Radio Wave Absorption (dB) | (B) Radio Wave Absorption after Exposure to High Power Radio Wave (dB) | (C) Radio Wave Absorption after Hygroscopicity Test (dB) | (D) Presence of Hygroscopicity |
|---|---|---|---|---|---|
| Example 1 | 1 | 20 | 20 | 20 | No |
| | 5 | 25 | 25 | 25 | |
| | 10 | 30 | 30 | 30 | |
| | 20 | 35 | 35 | 35 | |
| | 30 | 40 | 40 | 40 | |
| | 40 | 40 | 40 | 40 | |
| Example 2 | 1 | 20 | 20 | 19 | Little |
| | 5 | 25 | 25 | 23 | |
| | 10 | 30 | 30 | 28 | |
| | 20 | 35 | 35 | 32 | |
| | 30 | 40 | 40 | 35 | |
| | 40 | 40 | 40 | 35 | |
| Example 3 | 1 | 20 | 20 | 15 | Yes |
| | 5 | 25 | 25 | 22 | |
| | 10 | 30 | 30 | 24 | |
| | 20 | 35 | 35 | 28 | |
| | 30 | 40 | 40 | 30 | |
| | 40 | 40 | 40 | 30 | |
| Example 4 | 1 | 12 | 12 | 12 | No |
| | 5 | 16 | 16 | 16 | |
| | 10 | 20 | 20 | 20 | |
| | 20 | 25 | 25 | 25 | |
| | 30 | 20 | 20 | 20 | |
| | 40 | 15 | 15 | 15 | |

### INDUSTRIAL APPLICABILITY

According to the present invention, a low-cost radio wave absorber that has excellent radio wave absorption of the microwaves and the millimeter waves and hardly deteriorates the radio wave absorption property may be provided. Accordingly, the radio wave absorber for high power, which has conventionally been used only in special applications, becomes applicable to a wide range of uses.

### REFERENCE SIGNS LIST

- 10: Radio wave absorber
- 11: Base material

## Claims

1. A radio wave absorber for absorbing microwaves and millimeter waves, comprising:
a base material made of a porous compact containing composite oxide of calcium and aluminum; and
a conductive material added to the base material.

2. The radio wave absorber according to claim 1, wherein the base material made of the porous compact contains no calcium oxide.

3. The radio wave absorber according to claim 1 or 2, wherein a porosity of the porous compact is 10% to 70%.

4. The radio wave absorber according to any one of claims 1 to 3, wherein the conductive material is a fibrous carbon material with an aspect ratio of 100 or more, or carbon particles with a particle diameter of 0.2 µm or smaller.

5. The radio wave absorber according to claim 4, wherein conductive material content is 0.5 to 10.0 mass% when the fibrous carbon material is used as the conductive material, or is 2 to 30 mass% when the carbon particles are used as the conductive material.
